# EUROPEAN PATENT APPLICATION

(11) **EP 4 383 544 A1**
(43) Date of publication of application: **12.06.2024**
(21) Application number: 21952596.1
(22) Date of filing: 06.12.2021
(51) Int. Cl.: H02M 3/158

(54) **SOFT SWITCHING CIRCUIT, CIRCUIT BOARD ASSEMBLY, AND SWITCHING POWER SUPPLY**

(30) Priority: 05.08.2021 CN 202110898020
(71) Applicant: ZTE Corporation, Shenzhen, Guangdong 518057 (CN)
(72) Inventor: WANG, Linguo, Shenzhen, Guangdong 518057 (CN); ZHU, Junjie, Shenzhen, Guangdong 518057 (CN); WANG, Hao, Shenzhen, Guangdong 518057 (CN)
(74) Representative: Deambrogi, Edgardo
(86) International application number: PCT/CN2021/135795
(87) International publication number: WO 2023/010733

(57) **Abstract**

The present disclosure relates to the field of circuit design. The embodiments of the present disclosure provide a soft switch circuit, a circuit board assembly, and a switch power supply. The soft switch circuit includes a power supply, a first switch transistor, a second switch transistor, a third switch transistor, a fourth switch transistor, a capacitor, a main inductor, an auxiliary switch transistor, an auxiliary inductor, and a control unit, wherein the control unit is configured to: if the current of the main inductor is positive, turn on the auxiliary switch transistor before the first switch transistor and the fourth switch transistor are turned on; and if the current of the main inductor is negative, turn on the auxiliary switch transistor before the second switch transistor and the third switch transistor are turned on.

## Description

### Cross-Reference to Related Application

This disclosure is based on Chinese patent application No. 202110898020.5, filed on August 05, 2021, and claims priority to this Chinese patent application, the entire content of which is incorporated herein by reference.

### Technical Field

The present disclosure relates to the field of circuit design, and in particular, to a soft switch circuit, a circuit board assembly, and a switch power supply.

### Background

The switch power supply has advantages in terms of the volume and the characteristic of high conversion efficiency when only working in a switch state due to its high frequency, and thus is most widely applied in the current electronic technology field. With the continuous increase in demand for power of devices, people's requirements for power density and efficiency of the switch power supply are also continuously rising.

A traditional switch power supply includes a switch circuit. The switch circuit usually includes a plurality of switch devices. During a switching operation, each of the switch devices needs to bear a voltage and a current at the same time, and a parasitic capacitor in the switch device is charged and discharged. As the switching loss of a switch device is related to a product of a current flowing through the switch device and a voltage on the switch device, the switching loss of the switch device may be generated during each switching operation. If the switching frequency of a switch device in the switch circuit is continuously increased, the ratio between a total switching loss generated by all the switch devices in the switch circuit and an input power of the switch circuit is gradually increased, that is, the efficiency of the switch circuit is reduced. Hence, the switching loss of the switch device becomes a main factor for preventing the switching frequency of the switch device in the switch circuit from being further increased, and thus preventing the volume of the switch power supply applying the switch circuit from being further reduced.

### Summary

The embodiments of the present disclosure provide a soft switch circuit. The soft switch circuit includes a power supply, a first switch transistor, a second switch transistor, a third switch transistor, a fourth switch transistor, a capacitor, a main inductor, an auxiliary switch transistor, an auxiliary inductor, and a control unit; wherein a negative electrode of the power supply is grounded, a positive electrode of the power supply is connected to a first end of the first switch transistor, a second end of the first switch transistor is connected to a first end of the second switch transistor and a first end of the main inductor respectively, a second end of the second switch transistor is grounded, a second end of the main inductor is connected to a first end of the third switch transistor and a second end of the fourth switch transistor respectively, a second end of the third switch transistor is grounded, a first end of the fourth switch transistor is connected to a first end of the capacitor, and a second end of the capacitor is grounded, wherein a negative electrode of a body diode of each switch transistor serves as the first end of each switch transistor, and a positive electrode of a body diode of each switch transistor serves as the second end of each switch transistor; the auxiliary switch transistor and the auxiliary inductor are connected in series to form an auxiliary branch circuit, and the auxiliary branch circuit is connected in parallel to the main inductor; the control unit is connected to control ends of the first switch transistor, the second switch transistor, the third switch transistor, the fourth switch transistor, and the auxiliary switch transistor, respectively; and the control unit is configured to: in the case that the current of the main inductor is positive, turn on the auxiliary switch transistor before the first switch transistor and the third switch transistor are turned on; and in the case that the current of the main inductor is negative, turn on the auxiliary switch transistor before the second switch transistor and the fourth switch transistor are turned on.

The embodiments of the present disclosure further provide a circuit board assembly including the soft switch circuit described above.

The embodiments of the present disclosure further provide a switch power supply including the circuit board assembly described above.

### Brief Description of the Drawings

Fig. 1 is a circuit diagram of a soft switch circuit according to an embodiment of the present disclosure;
Fig. 2 is a first control waveform diagram of a soft switch circuit according to an embodiment of the present disclosure;
Fig. 3 is a second control waveform diagram of a soft switch circuit according to an embodiment of the present disclosure;
Fig. 4 is a circuit diagram of a soft switch circuit in which a main inductor and an auxiliary inductor form a coupled inductor according to an embodiment of the present disclosure;
Fig. 5 is a circuit diagram of a soft switch circuit in which two auxiliary MOS transistors are provided according to an embodiment of the present disclosure; and
Fig. 6 is a circuit diagram of a soft switch circuit in which two auxiliary MOS transistors are provided and a main inductor and an auxiliary inductor form a coupled inductor according to an embodiment of the present disclosure.

### Detailed Description of the Embodiments

The main objective of the embodiments of the present disclosure is to provide a soft switch circuit, a circuit board assembly, and a switch power supply, which provides a soft switch circuit capable of effectively reducing the switching loss of a switch device.

In the embodiments of the present disclosure, when each switch transistor needs to implement zero-voltage turn-on, a control unit turns on an auxiliary switch transistor, so that an auxiliary inductor and a main inductor are connected in parallel to form an equivalent inductor, where the inductance value of the equivalent inductor is less than the inductance value of the auxiliary inductor and the main inductor, and the inductance value of the equivalent inductor is smaller, so that the current on the main inductor can quickly decease to 0, thereby implementing zero-voltage turn-on of each switch transistor, further reducing the switching loss of each switch transistor.

To make the objectives, technical solutions, and advantages of the embodiments of the present disclosure clearer, the following describes the embodiments of the present disclosure in detail with reference to the drawings. A person of ordinary skill in the art may understand that, in the embodiments of the present application, many technical details are put forward to help a reader understand the present disclosure better. However, even without these technical details and various changes and modifications based on the following embodiments, the claimed technical solutions of the present disclosure can also be implemented. The division of the following embodiments is for convenience of description, and shall not constitute any limitation to specific implementations of the present disclosure. The embodiments may be referred to in combination with each other without any contradiction.

An embodiment of the present disclosure relates to a soft switch circuit. The soft switch circuit is provided in a switch power supply. The switching loss of each switch transistor in the switch power supply is generated when the switch transistor is turned on or turned off. The switch transistor is, for example, an MOS transistor. The parasitic output capacitor of the MOS transistor consumes energy when the MOS transistor is turned on, which is the main source of the switching loss of the switch power supply. The soft switch circuit in the present disclosure is used for releasing and recycling the energy on the parasitic output capacitor of the MOS transistor before the MOS transistor is turned on, so as to implement zero-voltage turn-on of the MOS transistor, and reduce the switching loss of the entire switch power supply, and then the switching frequency of the MOS transistor can be increased to further reduce the volume of the switch power supply applying the switch circuit.

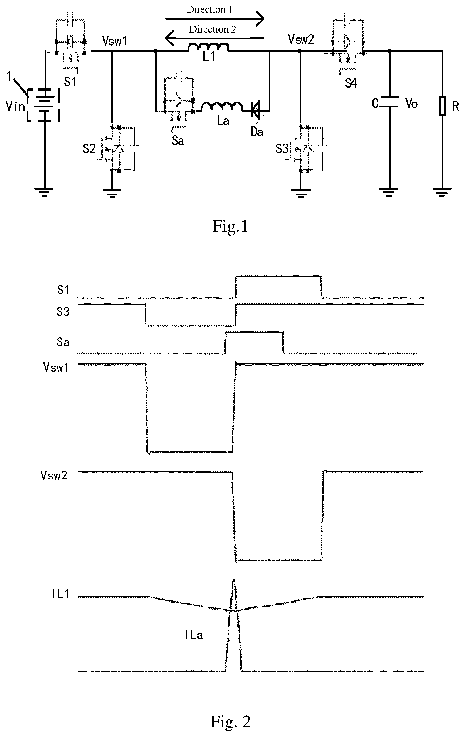

Referring to Fig. 1, the soft switch circuit includes a power supply 1, a first switch transistor S1, a second switch transistor S2, a third switch transistor S3, a fourth switch transistor S4, a capacitor C, a main inductor L1, an auxiliary switch transistor Sa, an auxiliary inductor La, and a control unit (not shown in the figure).

The circuit connection structure is as follows: a negative electrode of the power supply 1 is grounded, a positive electrode of the power supply 1 is connected to a first end of the first switch transistor S1, a second end of the first switch transistor S1 is connected to a first end of the second switch transistor S2 and a first end of the main inductor L1 respectively, a second end of the second switch transistor S2 is grounded, a second end of the main inductor L1 is connected to a first end of the third switch transistor S3 and a second end of the fourth switch transistor S4 respectively, a second end of the third switch transistor S3 is grounded, a first end of the fourth switch transistor S4 is connected to a first end of the capacitor C, and a second end of the capacitor C is grounded, wherein a negative electrode of a body diode of each switch transistor serves as the first end of each switch transistor, and a positive electrode of a body diode of each switch transistor serves as the second end of each switch transistor; the auxiliary switch transistor Sa and the auxiliary inductor La are connected in series to form an auxiliary branch circuit, and the auxiliary branch circuit is connected in parallel to the main inductor L1; the control unit is connected to control ends of the first switch transistor S1, the second switch transistor S2, the third switch transistor S3, the fourth switch transistor S4, and the auxiliary switch transistor Sa, respectively. S1, S2, S3 and S4 can all be MOS transistors. Fig. 1 shows an example in which S1, S2, S3 and S4 are all MOS transistors. The auxiliary switch transistor Sa can be an MOS transistor, and the control unit is specifically connected to a gate of each MOS transistor to control the conduction or disconnection between the first end (drain/source) and the second end (source/drain) of various MOS transistors.

The control unit may control the first switch transistor S1 and the second switch transistor S2 to be turned on complementarily, and control the third switch transistor S3 and the fourth switch transistor S4 to be turned on complementarily; or, when the current IL1 of the main inductor L1 is positive, that is, when IL1 only flows from the first end to the second end of the main inductor L1, the second switch transistor S2 and the fourth switch transistor S4 may be configured to be diodes; and when the current of the main inductor is negative, that is, when IL1 only flows from the second end to the first end of the main inductor L1, the first switch transistor S1 and the third switch transistor S3 may be configured to be diodes.

When the current IL1 of the main inductor L1 is positive, the control unit turns on the auxiliary switch transistor Sa before the first switch transistor S1 and the third switch transistor S3 are turned on; and when the current IL1 of the main inductor L1 is negative, the control unit turns on the auxiliary switch transistor Sa before the second switch transistor S2 and the fourth switch transistor S4 are turned on.

In this embodiment, a soft switch circuit capable of effectively reducing the switching loss of a switch device is provided. When each switch transistor needs to implement zero-voltage turn-on, a control unit turns on an auxiliary switch transistor, so that an auxiliary inductor and a main inductor are connected in parallel to form an equivalent inductor, where the inductance value of the equivalent inductor is less than the inductance value of the auxiliary inductor and the main inductor, and the inductance value of the equivalent inductor is smaller, so that the current on the main inductor can quickly decrease to 0, thereby implementing zero-voltage turn-on of each switch transistor, further reducing the switching loss of each switch transistor.

Specifically, the first switch transistor S1, the second switch transistor S2, and the main inductor L1 form a BUCK circuit, and the third switch transistor S3, the fourth switch transistor S4, and the main inductor L1 form a BOOST circuit. When S1, S2, S3 and S4 are all MOS transistors, the control unit may control the first switch transistor S1 and the second switch transistor S2 to be turned on complementarily, and specifically, may turn on or turn off the first switch transistor S1 to control the BUCK circuit to work. The control unit may further control the third switch transistor S3 and the fourth switch transistor S4 to be turned on complementarily, and specifically, may turn on or turn off the third switch transistor to control the BOOST circuit to work. Specifically, a load may also be connected to the first end of the capacitor C, and the voltage on the capacitor C is used to supply power to the load. Fig. 1 shows an example in which the load is a resistor R.

Generally, the inductance value of the main inductor L1 is set to be larger, which can reduce the ripple of the current transmitted by the main inductor L1. However, according to the formula U=L*di/dt, when the voltage U is approximately unchanged, the larger the inductance value L of the inductor is, the smaller the current change rate (di/dt) is; and when each switch transistor needs to implement soft switch turn-on (zero-voltage turn-on), because the inductance value of the main inductor L1 is larger, the current on the main inductor L1 cannot decrease to 0 in time, so that the voltage across each switch transistor cannot be equal, zero-voltage turn-on of each switch transistor cannot be implemented, and the switching loss is larger. If an inductor with a smaller inductance value is directly selected as the main inductor L1 to implement zero-voltage turn-on of each switch transistor, the ripple of the transmission current is excessively large, which still increases the loss of a transmission line in a turn-on state, as well as the turn-off loss.

When each switch transistor needs to implement zero-voltage turn-on, a control unit in the present disclosure turns on an auxiliary switch transistor Sa, so that an auxiliary inductor La and a main inductor L1 are connected in parallel to form an equivalent inductor, where the inductance value of the equivalent inductor is less than the inductance value of the auxiliary inductor La and the main inductor L1, and the inductance value of the equivalent inductor is smaller, so that the current on the main inductor L1 can quickly decrease to 0, thereby implementing zero-voltage turn-on of each MOS transistor, further reducing the switching loss of each MOS transistor.

In an embodiment, the inductance value of the auxiliary inductor La is less than the inductance value of the main inductor L1. When the inductance value of the auxiliary inductor is less than the inductance value of the main inductor, the inductance value of the equivalent inductor obtained by equivalence of the auxiliary inductor and the main inductor is certainly less than the inductance value of the main inductor; and the smaller the inductance value of the auxiliary inductor is, the smaller the inductance value of the equivalent inductor obtained by equivalence of the auxiliary inductor and the main inductor is. According to U=L*di/dt, when U is unchanged, the smaller L is, the larger the current change rate (di/dt) is, the current on the equivalent inductor can be changed to 0 more quickly, and then zero-voltage turn-on of each MOS transistor can be implemented more quickly, and when the switching frequency of each MOS transistor is gradually increased, zero-voltage turn-on can also be implemented better.

In an embodiment, a specific implementation for the control unit to control each MOS transistor and the auxiliary switch transistor Sa is provided.

Referring to the control waveform diagram of Fig. 2, Vsw1 and Vsw2 are voltages of two points in Fig. 1, the current on the main inductor L1 is IL1, and the current on the auxiliary inductor La is ILa. Before the first switch transistor S1 and the third switch transistor S3 are turned on, the control unit turns on the auxiliary switch transistor Sa first, and then turns off the second switch transistor S2 and the fourth switch transistor S4; and before the second switch transistor S2 and the fourth switch transistor S4 are turned on, the control unit turns on the auxiliary switch transistor Sa first, and then turns off the first switch transistor S1 and the third switch transistor S3, that is, before the MOS transistor which requires zero-voltage turn-on is turned on, the auxiliary switch transistor Sa is turned on first, and then the MOS transistor which is in a turn-on state is turned off.

Specifically, referring to the positions of Vsw1 and Vsw2 in Fig. 1, when the second switch transistor S2 and the fourth switch transistor S4 are in a turn-on state, the voltage Vsw1 of the second end of the first switch transistor S1 is equal to 0, and the voltage Vsw2 of the first end of the third switch transistor S3 is equal to the voltage Vo across the capacitor C. At this time, if the control unit controls the first switch transistor S1 and the third switch transistor S3 to be turned on at the same time, the switching loss of the first switch transistor S1 and the third switch transistor S3 are generated because a voltage exists across the first switch transistor S1 and a voltage exists across the third switch transistor S3.

In this embodiment, before the first switch transistor S1 and the third switch transistor S3 are turned on, the auxiliary switch transistor Sa is turned on first, so that the auxiliary inductor La and the main inductor L1 form an equivalent inductor with a smaller inductance value, thereby quickly decreasing the current (flowing from the first end to the second end of the main inductor L1) flowing through the equivalent inductor to 0, where the direction of the current refers to the direction 1 in Fig. 1, and starting to increase the current in a reverse direction (flowing from the second end to the first end of the main inductor L1), where the direction of the current refers to the direction 2 in Fig. 1. After the current flowing through the equivalent inductor decreases to 0, IL1 starts to be less than ILa, and at this time, the equivalent inductor starts to charge the first switch transistor S1, so that Vsw1 starts to increase from 0, and reversely charge the fourth switch transistor S4, so that Vsw2 starts to decrease from Vo. When Vsw1 increases to the voltage Vin output by the power supply 1, and Vsw2 decreases to 0, the voltage across the first switch transistor is 0, and the voltage across the third switch transistor is also 0. In this case, the control unit controls the first switch transistor S1 and the third switch transistor S3 to implement zero-voltage turn-on, thereby effectively reducing the switching loss of the first switch transistor S1 and the third switch transistor S3.

The principle that the control unit controls the second switch transistor S2 and the fourth switch transistor S4 to implement zero-voltage turn-on is the same as the above, and the difference lies in that: the equivalent inductor causes the current flowing from the second end to the first end of the main inductor L1 to decrease quickly to 0 and starts to increase the current in a reverse direction (flowing from the first end to the second end of the main inductor L1), until Vsw1 decreases from Vin to 0 and Vsw2 increases from 0 to Vo, the control unit controls the second switch transistor S2 and the fourth switch transistor S4 to implement zero-voltage turn-on, thereby effectively reducing the switching loss of the second switch transistor S2 and the fourth switch transistor S4.

In an embodiment, another specific implementation for the control unit to control each switch transistor and the auxiliary switch transistor Sa is provided.

Before the first switch transistor S1 and the third switch transistor S3 are turned on, the control unit turns off the second switch transistor S2 and the fourth switch transistor S4 first, and then turns on the auxiliary switch transistor Sa; and before the second switch transistor S2 and the fourth switch transistor S4 are turned on, the control unit turns off the first switch transistor S1 and the third switch transistor S3 first, and then turns on the auxiliary switch transistor Sa.

The difference between the implementation in this embodiment and the implementation in the foregoing embodiment mainly lies in that:
in the foregoing embodiment, before the first switch transistor S1 and the third switch transistor S3 are turned on, the control unit turns on the auxiliary switch transistor Sa first, and then turns off the second switch transistor S2 and the fourth switch transistor S4. Because the auxiliary switch transistor Sa is turned on before the second switch transistor S2 and the fourth switch transistor S4 are turned off, the voltage on the equivalent inductor continues to be equal to Vo for a period of time and starts to decrease after the second switch transistor S2 and the fourth switch transistor S4 are turned off; therefore, the increase speed of the current ILa on La is fast, which allows for implementation of zero-voltage turn-on of the first switch transistor S1 and the third switch transistor S3 at the same time, but the large current ILa on La increases the loss of the entire soft switch circuit in a turn-on state, as well as the turn-off loss of each switch transistor.

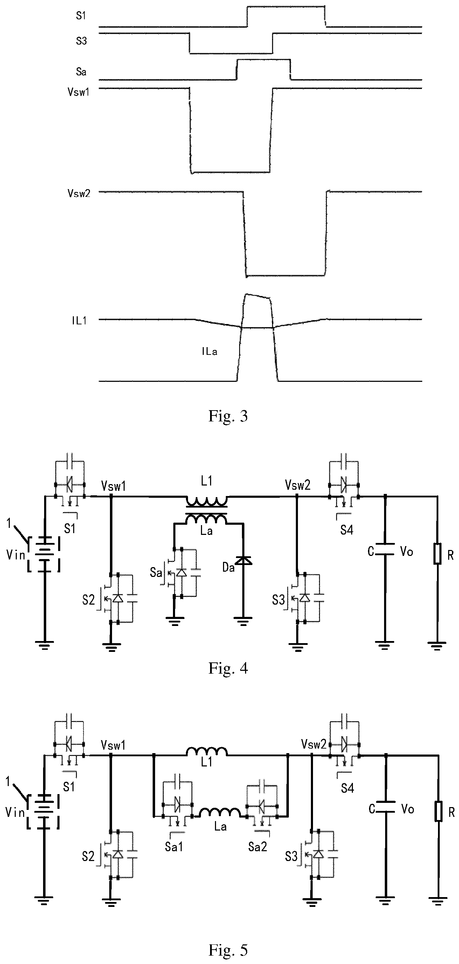

However, in this embodiment, referring to the control waveform diagram of Fig. 3, before the first switch transistor S1 and the third switch transistor S3 are turned on, the control unit turns off the second switch transistor S2 and the fourth switch transistor S4 first, and then turns on the auxiliary switch transistor Sa. Starting from turning on the auxiliary switch transistor Sa, the voltage on the equivalent inductor starts to decrease from Vo. For this reason, the increase speed of the current ILa on La is slow, and the current ILa on La is smaller, which can effectively reduce the loss of the entire soft switch circuit in a turn-on state as well as the turn-off loss of each switch transistor. In addition, the current of the equivalent inductor may decrease Vsw2 synchronously while increasing Vsw1. However, as the voltage Vin output by the power supply 1 may not be equal to the voltage Vo across the capacitor C, in this case, the moment when Vsw1=Vin and Vsw2=0 may not exist. If the first switch transistor S1 and the third switch transistor S3 are turned on at the same time, there is a difference in the effect of zero-voltage turn-on of the two transistors. Therefore, in the present disclosure, the first switch transistor S1 and the third switch transistor S3 may be turned on sequentially at a first preset time interval, the first switch transistor S1 is turned on when Vsw1=Vin, the third switch transistor S3 is turned on when Vsw2=0, and the third switch transistor S3 is turned on first when Vin>Vo, otherwise, the first switch transistor S1 is turned on first. Fig. 3 shows an example in which the first switch transistor S1 is turned on first, so as to ensure implementation of zero-voltage turn-on of both switch transistors, and reduce the switching loss of the entire soft switch circuit. By the same reasoning, the second switch transistor S2 and the fourth switch transistor S4 may be turned on sequentially at a second preset time interval, and the first preset time interval and the second preset time interval may be equal or may be unequal.

In an embodiment, when the voltage Vin output by the power supply 1 is approximately equal to the voltage Vo across the capacitor C, the control unit controls the first switch transistor S1 and the third switch transistor S3 to be turned on at the same time, that is, the first preset time interval is 0, and the control unit controls the second switch transistor S2 and the fourth switch transistor S4 to be turned on at the same time, that is, the second preset time interval is 0. In this embodiment, when Vin is close to Vo, the control unit may be directly configured to control the first switch transistor and the third switch transistor to be turned on at the same time, thereby simplifying the control policy.

In an embodiment, the control unit may also turn off the auxiliary switch transistor Sa after the first switch transistor S1 and the third switch transistor S3 are turned on; and turn off the auxiliary switch transistor Sa after the second switch transistor S2 and the fourth switch transistor S4 are turned on. In this embodiment, if the auxiliary switch transistor is turned off before the first switch transistor and the third switch transistor are turned on, the current on the auxiliary branch circuit tends to be large when the auxiliary switch transistor is turned off; therefore, the auxiliary switch transistor may be turned off after the first switch transistor and the third switch transistor are turned on, so as to decrease the current of the auxiliary branch circuit when the auxiliary switch transistor is turned off as far as possible, thereby reducing the turn-off loss generated by turning off the auxiliary switch transistor, and further reducing the switching loss of the entire soft switch circuit.

In an embodiment, the control unit may specifically turn off the auxiliary switch transistor Sa after the first switch transistor S1 and the third switch transistor S3 are turned on and when the current on the auxiliary branch circuit is 0; and turn off the auxiliary switch transistor Sa after the second switch transistor S2 and the fourth switch transistor S4 are turned on and when the current on the auxiliary branch circuit is 0. In this embodiment, when the current on the auxiliary branch circuit is equal to 0, the control switch specifically turns off the auxiliary switch transistor, so as to implement zero-current turn-off of the auxiliary switch transistor, thereby further reducing the turn-off loss generated by turning off the auxiliary switch transistor, and further reducing the switching loss of the entire soft switch circuit.

In an embodiment, the soft switch circuit further includes an auxiliary diode Da, the auxiliary diode Da is provided on the auxiliary branch circuit, and a conducting direction of the auxiliary diode Da on the auxiliary branch circuit is from the second end of the main inductor L1 to the first end of the main inductor L1. The specific position of the auxiliary diode Da on the auxiliary branch circuit is not limited herein. Fig. 1 shows an example in which the auxiliary diode Da is provided between the auxiliary inductor La and the second end of the main inductor L1.

In this embodiment, after the zero-voltage turn-on of the first switch transistor and the third switch transistor, the current of the equivalent inductor flowing from the second end to the first end of the main inductor may decrease to 0, and the current reversely flows from the first end to the second end of the main inductor. In this period of time when the current flows from the first end to the second end of the main inductor, because an auxiliary diode exists, the current on the auxiliary switch transistor is 0, and turning off the auxiliary switch transistor in this period of time can implement zero-current turn-off of the auxiliary switch transistor, so as to further reduce the switching loss of the entire soft switch circuit.

In an embodiment, referring to Fig. 4, the auxiliary inductor La is magnetically coupled in parallel to the main inductor L1. Specifically, a coil of the auxiliary inductor La is provided on a magnetic core of the main inductor L1, and the auxiliary inductor La exchanges energy with the main inductor L1 by using a magnetic field. In this embodiment, the auxiliary inductor is magnetically coupled in parallel to the main inductor. Specifically, a coil of the auxiliary inductor is directly provided on a magnetic core of the main inductor to form a coupled inductor together with the main inductor, without an additional magnetic core, thereby reducing the volume of the entire soft switch circuit to a certain extent; energy is directly transferred between the auxiliary inductor and the main inductor by using a magnetic field, thereby realizing electrical isolation between the main inductor and the auxiliary inductor, without adding an isolation apparatus. In addition, two ends of an auxiliary branch circuit may be connected to other potentials, for example, both are connected to the same reference ground as that of a control unit, and it is unnecessary to perform floating driving on an auxiliary switch transistor, thereby reducing driving requirements.

In an embodiment, referring to Fig. 5, the auxiliary switch transistor Sa includes a first auxiliary MOS transistor Sa1 and a second auxiliary MOS transistor Sa2 connected in series, wherein a conducting direction of the body diode of the first auxiliary MOS transistor Sa1 on the auxiliary branch circuit is from the first end of the main inductor L1 to the second end of the main inductor L1, and a conducting direction of the body diode of the second auxiliary MOS transistor Sa2 on the auxiliary branch circuit is from the second end of the main inductor L1 to the first end of the main inductor L1.

If electric energy is transmitted in the direction from the power supply 1 to the capacitor C, before the first switch transistor S1 and the third switch transistor S3 are turned on, the control unit turns on the first auxiliary MOS transistor Sa1, and turns off the second auxiliary MOS transistor Sa2. At this time, the direction of the body diode of the second auxiliary MOS transistor Sa2 is obviously the same as the direction of the auxiliary diode Da in the embodiment corresponding to Fig. 1. Therefore, zero-current turn-off of the auxiliary switch transistor can also be implemented, so as to further reduce the switching loss of the entire soft switch circuit. Before the second switch transistor S2 and the fourth switch transistor S4 are turned on, the control unit turns on the second auxiliary MOS transistor Sa2, and turns off the first auxiliary MOS transistor Sa1. By the same reasoning, the body diode of the first auxiliary MOS transistor Sa1 can also implement zero-current turn-off of the auxiliary switch transistor, so as to further reduce the switching loss of the entire soft switch circuit.

If electric energy is transmitted in the direction from the capacitor C to the power supply 1, before the first switch transistor S1 and the third switch transistor S3 are turned on, the control unit turns on the second auxiliary MOS transistor Sa2, and turns off the first auxiliary MOS transistor Sa1; and before the second switch transistor S2 and the fourth switch transistor S4 are turned on, the control unit turns on the first auxiliary MOS transistor Sa1, and turns off the second auxiliary MOS transistor Sa2.

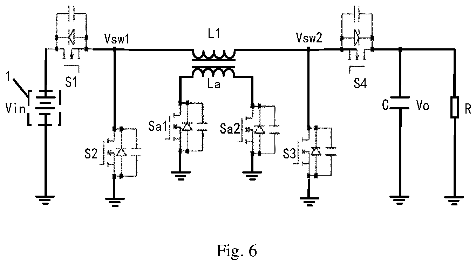

Referring to Fig. 6, a coil of the auxiliary inductor La is provided on a magnetic core of the main inductor L1. In this case, one end of the first auxiliary MOS transistor Sa1 and one end of the second auxiliary MOS transistor Sa2 on two sides of the auxiliary inductor La can be connected to the same reference ground as that of a control unit, and it is unnecessary to perform floating driving on the first auxiliary MOS transistor Sa1 and the second auxiliary MOS transistor Sa2, thereby reducing driving requirements.

In this embodiment, when electric energy is transmitted bi-directionally between a power supply and a capacitor, each MOS transistor is enabled to implement zero-voltage turn-on, the implementation principle is the same as that in the foregoing embodiment, and zero-current turn-off of an auxiliary switch transistor can also be implemented, so as to further reduce the switching loss of the entire soft switch circuit.

An embodiment of the present disclosure relates to a circuit board assembly including the soft switch circuit of the foregoing embodiment.

An embodiment of the present disclosure relates to a switch power supply including the circuit board assembly of the foregoing embodiment.

A person of ordinary skill in the art may understand that the foregoing embodiments are specific embodiments for implementing the present disclosure, and in practical applications, various changes may be made in form and details without departing from the spirit and scope of the present disclosure.

## Claims

1. A soft switch circuit, wherein the soft switch circuit comprises a power supply, a first switch transistor, a second switch transistor, a third switch transistor, a fourth switch transistor, a capacitor, a main inductor, an auxiliary switch transistor, an auxiliary inductor, and a control unit;
a negative electrode of the power supply is grounded, a positive electrode of the power supply is connected to a first end of the first switch transistor, a second end of the first switch transistor is connected to a first end of the second switch transistor and a first end of the main inductor respectively, a second end of the second switch transistor is grounded, a second end of the main inductor is connected to a first end of the third switch transistor and a second end of the fourth switch transistor respectively, a second end of the third switch transistor is grounded, a first end of the fourth switch transistor is connected to a first end of the capacitor, and a second end of the capacitor is grounded, wherein a negative electrode of a body diode of each switch transistor serves as the first end of each switch transistor, and a positive electrode of a body diode of each switch transistor serves as the second end of each switch transistor;
the auxiliary switch transistor and the auxiliary inductor are connected in series to form an auxiliary branch circuit, and the auxiliary branch circuit is connected in parallel to the main inductor;
the control unit is connected to control ends of the first switch transistor, the second switch transistor, the third switch transistor, the fourth switch transistor, and the auxiliary switch transistor, respectively; and
the control unit is configured to, in a case that a current of the main inductor is positive, turn on the auxiliary switch transistor before the first switch transistor and the third switch transistor are turned on; and in a case that the current of the main inductor is negative, turn on the auxiliary switch transistor before the second switch transistor and the fourth switch transistor are turned on.

2. The soft switch circuit according to claim 1, wherein,
the control unit is configured to, before the first switch transistor and the third switch transistor are turned on, turn on the auxiliary switch transistor first, and then turn off the second switch transistor and the fourth switch transistor; and before the second switch transistor and the fourth switch transistor are turned on, turn on the auxiliary switch transistor first, and then turn off the first switch transistor and the third switch transistor.

3. The soft switch circuit according to claim 1, wherein,
the control unit is configured to, before the first switch transistor and the third switch transistor are turned on, turn off the second switch transistor and the fourth switch transistor first, and then turn on the auxiliary switch transistor; and before the second switch transistor and the fourth switch transistor are turned on, turn off the first switch transistor and the third switch transistor first, and then turn on the auxiliary switch transistor.

4. The soft switch circuit according to claim 3, wherein,
the control unit is further configured to turn on the first switch transistor and the third switch transistor at a first preset time interval, and turn on the second switch transistor and the fourth switch transistor at a second preset time interval.

5. The soft switch circuit according to any of claims 1 to 4, wherein,
the control unit is further configured to turn off the auxiliary switch transistor after the first switch transistor and the third switch transistor are turned on; and turn off the auxiliary switch transistor after the second switch transistor and the fourth switch transistor are turned on.

6. The soft switch circuit according to claim 5, wherein,
the control unit is configured to, after the first switch transistor and the third switch transistor are turned on and in a case that the current on the auxiliary branch circuit is 0, turn off the auxiliary switch transistor; and after the second switch transistor and the fourth switch transistor are turned on and in the case that the current on the auxiliary branch circuit is 0, turn off the auxiliary switch transistor.

7. The soft switch circuit according to claim 1, wherein the soft switch circuit further comprises an auxiliary diode;
the auxiliary diode is provided on the auxiliary branch circuit, and a conducting direction of the auxiliary diode on the auxiliary branch circuit is from the second end of the main inductor to the first end of the main inductor.

8. The soft switch circuit according to claim 1, wherein the auxiliary switch transistor comprises a first auxiliary MOS transistor and a second auxiliary MOS transistor connected in series;
a conducting direction of the body diode of the first auxiliary MOS transistor on the auxiliary branch circuit is from the first end of the main inductor to the second end of the main inductor, and a conducting direction of the body diode of the second auxiliary MOS transistor on the auxiliary branch circuit is from the second end of the main inductor to the first end of the main inductor;
the control unit is configured to, in a case that electric energy is transmitted from the power supply to the capacitor, before the first switch transistor and the third switch transistor are turned on, turn on the first auxiliary MOS transistor and turn off the second auxiliary MOS transistor, and before the second switch transistor and the fourth switch transistor are turned on, turn on the second auxiliary MOS transistor and turn off the first auxiliary MOS transistor; and
the control unit is further configured to, in a case that the electric energy is transmitted from the capacitor to the power supply, before the first switch transistor and the third switch transistor are turned on, turn on the second auxiliary MOS transistor and turn off the first auxiliary MOS transistor, and before the second switch transistor and the fourth switch transistor are turned on, turn on the first auxiliary MOS transistor and turn off the second auxiliary MOS transistor.

9. The soft switch circuit according to any one of claims 1 to 8, wherein the auxiliary inductor is magnetically coupled in parallel to the main inductor.

10. The soft switch circuit according to any one of claims 1 to 9, wherein the inductance value of the auxiliary inductor is less than the inductance value of the main inductor.

11. A circuit board assembly comprising the soft switch circuit according to any of claims 1 to 10.

12. A switch power supply comprising the circuit board assembly according to claim 11.
